Europäisches Patentamt

European Patent Office

Office européen des brevets

(19)

(11) Veröffentlichungsnummer: **0 285 798**

**A2**

(12) **EUROPÄISCHE PATENTANMELDUNG**

(21) Anmeldenummer: 88103017.5

(22) Anmeldetag: 29.02.88

(51) Int. Cl.⁴ **G01R 31/28** , **G01R 31/02**

(30) Priorität: 31.03.87 DE 3710595

(43) Veröffentlichungstag der Anmeldung:
12.10.88 Patentblatt 88/41

(84) Benannte Vertragsstaaten:
**AT BE CH DE FR GB IT LI NL**

(71) Anmelder: **Siemens Aktiengesellschaft Berlin und München**
**Wittelsbacherplatz 2**
**D-8000 München 2(DE)**

(72) Erfinder: **Doemens, Günter, Dr.-Ing.**
**Eichenfeldstrasse 4**
**D-8150 Holzkirchen(DE)**

(54) **Vorrichtung für die elektrische Funktionsprüfung von Verdrahtungsfeldern, insbesondere von Leiterplatten.**

(57) Bei der elektrischen Funktionsprüfung von Verdrahtungsfeldern, insbesondere von Leiterplatten (Lp) erfolgt die Kontaktierung ausgewählter Meßstellen (M10, M11) über Gasentladungskanäle (G10, G11). Die Anzahl der für die Ansteuerung der einzelnen Meßstellen (M10, M11) erforderlichen Zuleitungen soll drastisch reduziert werden.

Bei der neuen Vorrichtung ist jeder Gasentladungskanal durch eine zugeordnete Sammelleitung (S10, S11) und durch die steuerbare Beaufschlagung eines zwischen dem Gasentladungskanal (G10, G11) und der zugeordneten Sammelleitung (S10, S11) angeordneten Photoleiters (P10, P11) mit Licht (L) auswählbar.

FIG 1

EP 0 285 798 A2

# Vorrichtung für die elektrische Funktionsprüfung von Verdrahtungsfeldern, insbesondere von Leiterplatten

Die Erfindung betrifft eine Vorrichtung für die elektrische Funktionsprüfung von Verdrahtungsfeldern, insbesondere von Leiterplatten, nach dem Oberbegriff des Anspruchs 1.

In Prüfautomaten und Prüfadaptern für unbestückte und bestückte Leiterplatten sowie für Verdrahtungsfelder in Löt-oder Crimptechnik wird die Kontaktierung der ausgewählten Meßstellen in der Regel über federnde Prüfspitzen vorgenommen. Die entsprechend dem Rastermaß eines zu prüfenden Verdrahtungsfeldes angeordneten federnden Prüfspitzen werden mittels Federhülsen befestigt, die in eine Trägerplatte eingepreßt sind und in die man die Prüfspitzen einschiebt. Bei der Auswahl der Prüfspitzen entscheiden üblicherweise der kleinste Abstand der Meßstellen zueinander sowie die Strombelastung über den Durchmesser der federnden Prüfspitzen, wobei als unteres Grenzmaß für den Durchmesser jedoch 0,69 mm genannt werden (Elektronik Produktion & Prüftechnik, November 1979, Seiten 472 und 473).

Mit den bekannten Vorrichtungen für die elektrische Funktionsprüfung von Leiterplatten werden zwischen den durch Rasterpunkte entsprechend dem Layout gebildeten Prüfstellen Leitfähigkeits-und Isolationsmessungen durchgeführt. Da die für die Ankontaktierung der Prüfstellen vorgesehenen federnden Prüfspitzen im Raster der Leiterplatte angeordnet werden müssen, stößt die Realisierung derartiger Vorrichtungen bei abnehmenden Rastermaß und größer werdenden Flächen der Leiterplatten zunehmend auf prinzipielle Schwierigkeiten. So ist eine Anordnung der federnden Prüfspitzen in Rastermaßen unter einem Millimeter bei einer sicheren mechanischen Kontaktierung der Prüfstellen feinwerktechnisch kaum mehr be herrschbar. Mit der Anzahl der Meßstellen, die beispielsweise Hunderttausend betragen kann, steigt auch die Anzahl der erforderlichen Zuleitungen und Schaltelemente, wodurch ein erheblicher gerätetechnischer Aufwand und entsprechend hohe Kosten verursacht werden. Außerdem nimmt mit der Anzahl der Meßstellen auch die Wahrscheinlichkeit einer vollständigen Kontaktierung der Leiterplatten erheblich ab.

Aus der EP-A-0 102 565 ist eine Vorrichtung für die elektrische Funktionsprüfung von Verdrahtungsfedern bekannt, bei welcher die bisher übliche ohm'sche Kontaktierung der Meßstellen durch eine berührungslose ionische Kontaktierung über Gasentladungsstrecken ersetzt wird. Hierzu wird in eine auf die Verdrahtungsfelder aufsetzbare Trägerplatte eine Vielzahl von mit Elektroden versehenen Gasentladungskanälen eingebracht, wobei die im Rahmen der Verdrahtungsfelder angeordneten Gasentladungskanäle zu den Meßstellen hin offen sind. Sind nun zwei ausgewählte Meßstellen beispielsweise durch eine Leiterbahn elektrisch leitend miteinander verbunden, so bilden die zugeordneten Gasentladungskanäle zwei in Reihe geschaltete Gasentladungsstrecken, die durch Anlegen einer hinreichend hohen Spannung an die Elektroden gezündet werden können. Mit der Zündung der Gasentladungen erfolgt dann ein Stromtransport, der zu Prüfzwecken ausgewertet werden kann. Unterbleibt die Zündung der Gasentladungen oder fließt nach einer Zündung ein zu geringer Strom, so kann auf eine unterbrochene oder von vornerein nicht existierende elektrisch leitende Verbindung zwischen den ausgewählten Meßstellen geschlossen werden. Wird der an die Elektroden angelegten Spannung eine Wechselspannung überlagert, so kann die daraus resultierende Stromänderung phasenempfindlich zur angelegten Wechselspannung gemessen und für die Bestimmung des Widerstandes einer zwischen den ausgewählten Meßstellen bestehenden Verbindung herangezogen werden. Die bekannte Vorrichtung ermöglicht also Leitfähigkeits-und Isolationsmessungen, wobei durch das Vermeiden von ohm'-schen Kontakten eine sehr hohe Zuverlässigkeit erreicht wird. Durch das Prinzip der ionischen Kontaktierung der Meßstellen über in äußerst geringen Abmessungen reali sierbare Gasentladungskanäle können dann insbesondere auch Verdrahtungsfelder mit kleinen Rastermaßen der Meßstellen bis herab zu 0,1 mm zuverlässig geprüft werden. Bei einer hohen Anzahl der Meßstellen eines zu prüfenden Verdrahtungsfeldes treten jedoch nach wie vor Probleme auf, die durch die zahlreichen Zuleitungen und Schaltelemente für den Anschluß der Elektroden der Gasentladungskanäle zurückzuführen sind.

Der Erfindung liegt die Aufgabe zugrunde, bei einer Vorrichtung der eingangs genannten Art die Anzahl der Zuleitungen drastisch zu reduzieren.

Diese Aufgabe wird erfindungsgemäß durch die kennzeichnenden Merkmale des Anspruchs 1 gelöst.

Der Erfindung liegt die Erkenntnis zugrunde, daß der Anschluß der Elektroden von mehreren Gasentladungskanälen unter der Voraussetzung über gemeinsame Sammelleitungen vorgenommen werden können, daß für die Einleitung einer Gasentladung in den den ausgewählten Meßstellen zugeordneten Gasentladungskanälen als zusätzliche Bedingung die Beaufschlagung eines zwischen dem Gasentladungskanal und der zugeordneten Sammelleitung angeordneten Photoleiters mit Licht erforderlich ist. Mit der erfindungsgemäßen Adressierung der ausgewählten Meßstellen bzw. der den ausgewählten Meßstellen zugeordneten Gasentladungskanäle kann die Anzahl der Zuleitungen erheblich reduziert werden, zumal den Sammelleitungen auch eine größere Anzahl von Gasentladungskanälen zugeordnet werden kann. Neben einer erheblichen Verringerung des Verdrahtungsaufwandes wird insbesondere die technische Machbarkeit von Vorrichtungen für die elektrische Funktionsprüfung von Leiterplatten mit großen Leiterplattenformaten und kleinen Rastermaßen wesentlich erleichtert und somit auch eine entscheidende Senkung der Herstellkosten bewirkt. Der zusätzliche Aufwand für die adressierbare Beaufschlagung der zwischen den Gasentladungskanälen und den zugeordneten Sammelleitungen angeordneten Photoleiter mit Licht ist gegenüber den genannten Vorteilen als gering einzustufen. Durch die Beaufschlagung der den ausgewählten Meßstellen zugeordneten Photoleiter mit Licht werden diese Photoleiter niederohmig und es kann ein hinreichender Strom zur Zündung und Aufrechterhaltung einer Gasentladung fließen.

Bei der erfindungsgemäßen Vorrichtung für die elektrische Funktionsprüfung von Verdrahtungsfeldern werden die Meßstellen vorzugsweise ionisch kontaktiert, d.h. die Meßstellen auf der Leiterplatte bilden unmittelbar Elektroden der zugeordneten Gasentladungskanäle. Durch das Vermeiden von ohm'schen Kontakten wird dabei eine sehr hohe Zuverlässigkeit erreicht. Die Vorteile der erfindungsgemäßen Adressierung von Meßstellen bzw. Gasentladungskanälen mit einer erheblichen Reduzierung des Verdrahtungsaufwandes ergeben sich jedoch auch dann, wenn eine ohm'sche Kontaktierung der Meßstellen durch am unteren Ende der Gasentladungskanäle angeordnete federnde Prüfspitzen vorgenommen wird. Diese federnden Prüfspitzen bilden dann eine der beiden Elektroden der Gasentladungsstrecken, d.h. sie werden an dem der Spitze gegenüberliegenden Ende ionisch kontaktiert und können mit geringeren Durchmessern realisiert werden, als die mit einer Verdrahtung verbundenen herkömmlichen Prüfspitzen. Die geringen Rasterabmessungen bei einer ionischen Kontaktierung mit zu den Meßstellen hin offenen Gasentladungskanälen können mit Prüfspitzen jedoch nicht erreicht werden.

Gemäß einer bevorzugten Ausgestaltung der Erfindung sind die den Gasentladungskanälen zugeordneten Photoleiter reihenweise über die Sammelleiutngen miteinander verbunden. Eine derartige reihenweise Zusammenfassung der Anschlüsse der Photoleiter ist insbesondere auf eine regelmäßige Rasteranordnung der Meßstellen abgestimmt, wie sie beispielsweise bei Leiterplatten in der Regel vorhanden ist. Es ergibt sich dann eine übersichtliche und besonders einfache Verlegung der Sammelleitungen.

Weiterhin ist es besonders vorteilhaft, wenn die Sammelleitungen quer zu den Hauptrichtungen der Verdrahtung der zu prüfenden Verdrahtungsfeldern verlaufen. Durch diese Maßnahme wird dem Umstand Rechnung getragen, daß zwei ausgewählten Meßstellen nicht die gleiche Sammelleitung zugeordnet sein darf. Verlaufen die Sammelleitungen beispielsweise unter einem Winkel von 45° zu den Hauptrichtungen der Verdrahtung, so können durch eine Verdrehung der gesamten Trägerplatte um einen Winkel von 90° oder 270° relativ zur Verdrahtung sämtliche Meßstellen sichergefaßt werden.

Gemäß einer besonders bevorzugten Ausgestaltung der Erfindung ist vorgesehen, daß jede Sammelleitung über jeweils einen Photowiderstand mit zwei Leitungen verbunden ist und daß jeder Photowiderstand steuerbar mit Licht beaufschlagbar ist. Durch die Photowiderstände wird eine Art "optischer Multiplexer" für die Adressierung der Sammelleitungen gebildet. Neben der steuerbaren Beaufschlagung von Photoleitern und Photowiderständen mit Licht sind dann nur noch zwei Leitungen für die Ansteuerung der Meßstellen erforderlich.

Weiterhin hat es sich als zweckmäßig herausgestellt, wenn die Sammelleitungen bogenförmig um die Gasentladungskanäle geführt sind. Sind dann auch noch zusätzlich die Photoleiter bogenförmig um die Gasentladungskanäle geführt, so ergeben sich für die Anordnung von Sammelleitungen und Photoleitern auf der Trägerplatte optimale Voraussetzungen. Außerdem können bei einer derartigen Anordnung Lichtstrahlen in die ausgewählten Gasentladungskanäle eindringen und dort die Zündung von Gasentladungen begünstigen.

Gemäß einer weiteren bevorzugten Ausgestaltung der Erfindung bestehen die Photoleiter aus Cadmiumselenid oder Cadmiumsulfid. Diese beiden photoleitenden Materialien zeichnen sich durch erhebliche Leitfähigkeitserhöhung bei Lichteinstrahlung aus.

Im Prinzip könnten die Photoleiter selbst als Elektroden der Gasentladungskanäle herangezogen werden. Eine höhere Funktionssicherheit der gesamten Vorrichtung wird jedoch dadurch erzielt, daß die Photoleiter an zugeordnete Elektroden der Gasentladungskanäle angeschlossen werden.

Vorzugsweise sind die Sammelleitungen in Dünnfilmtechnik hergestellt, d.h. es kann auf Techniken zurückgegriffen werden, die sich bei der Herstellung von Schichtschaltungen bereits bewährt haben. Diese Vorteile ergeben sich dann auch bei der Herstellung der Photoleiter, der Photowiderstände und der beiden Leitungen in Dünnfilmtechnik. Dementsprechend ist es besonders günstig, wenn die Sammelleitungen, die Photoleiter, die Photowiderstände und die beiden Leitungen in Dünnfilmtechnik auf die Trägerplatte aufgebracht sind.

Die steuerbare Beaufschlagung der Photoleiter und/oder der Photowiderstände mit Licht kann durch unmittelbar darüber angeordnete Masken vorgenommen werden, deren gegebenenfalls steuerbare Öffnungen das Licht einer Lichtquelle nur an den gewünschten Stellen durchlassen. Die Abbildung der jeweiligen Löcher einer Maske auf die ausgewählten Photoleiter und/oder Photowiderstände ist ebenfalls möglich. Gemäß einer besonders bevorzugten Ausgestaltung der Erfindung ist jedoch vorgesehen, daß die Photoleiter und/oder Photowiderstände über einen ablenkbaren Strahl mit Licht beaufschlagbar sind. Dabei hat es sich im Hinblick auf die erwünschte Leitfähigkeitserhöhung als besonders günstig erwiesen, wenn der Strahl durch einen fokussierbaren Laserstrahl gebildet ist.

Gemäß einer weiteren bevorzugten Ausgestaltung der Erfindung ist zur Ablenkung des Strahls ein akusto-optischer Ablenker vorgesehen, der sich durch besonders geringe Positionierzeiten auszeichnet.

Bei entsprechend geringen Positionierzeiten des ablenkbaren Strahls können die Photowiderstände dann auch seriell mit Licht beaufschlagt werden. Dies wird durch eine gegenüber der Rekombinationszeit bzw. Abklingzeit der Photowiderstände kleine Positionierzeit ermöglicht. Bei der Verwendung des bereits erwähnten "optischen Multiplexers" ist es dementsprechend zweckmäßig die Photoleiter und die Photowiderstände seriell mit Licht zu beaufschlagen. Die steuerbare Lichtbeaufschlagung kann dann beispielsweise über einen einzigen Laser vorgenommen werden, wodurch sich eine weitere erhebliche Reduzierung des gerätetechnischen Aufwandes für die Ansteuerung der Meßstellen ergibt.

Ausführungsbeispiele der Erfindung sind in der Zeichnung dargestellt und werden im folgenden näher beschrieben.

Es zeigen

Fig. 1 das Grundprinzip einer erfindungsgemäßen Vorrichtung für die elektrische Funktionsprüfung von Leiterplatten,

Fig. 2 die Anordnung von Sammelleitungen, Photoleitern, Gasentladungskanälen, Meßstellen und Leiterbahnen in stark vereinfachter schematischer Darstellung,

Fig. 3 eine Draufsicht auf eine Trägerplatte auf welche Sammelleitungen, Photoleiter und Elektroden in Dünnfilmtechnik aufgebracht sind,

Fig. 4 das Grundprinzip einer erfindungsgemäßen Einrichtung für die elektrische Funktionsprüfung von Leiterplatten mit einem zusätzlichen optischen Multiplexer für die Ansteuerung der Sammelleitungen,

Fig. 5 eine perspektivische Gesamtdarstellung der Vorrichtung gemäß Fig. 4,

Fig. 6 eine erste Variante des in Fig. 1 aufgezeigten Grundprinzips und

Fig. 7 eine zweite Variante des in Fig. 1 aufgezeigten Grundprinzips.

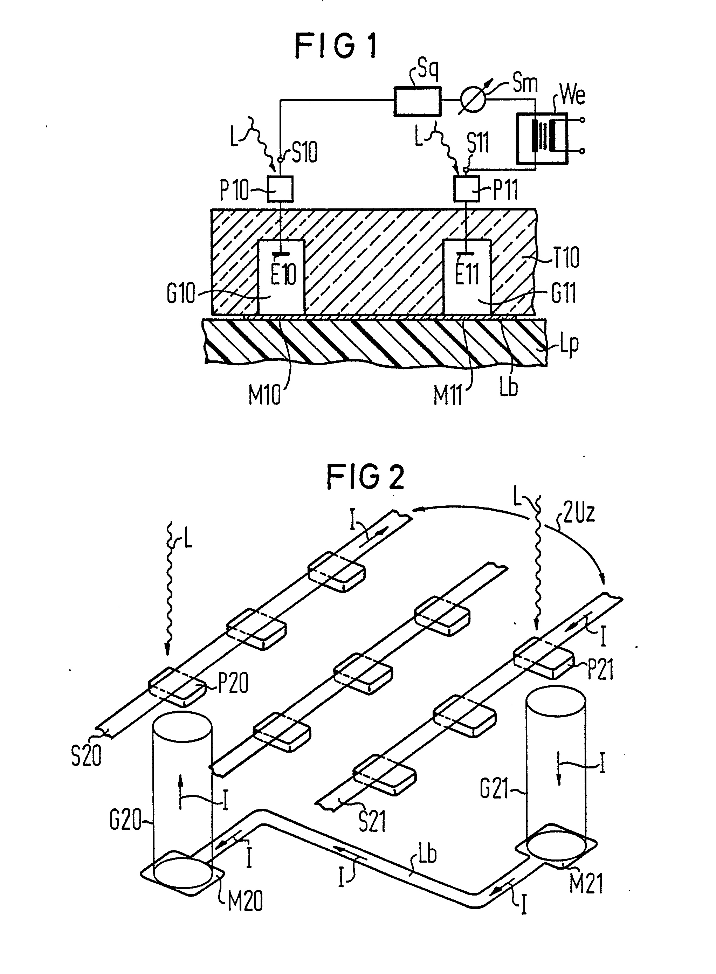

Fig. 1 zeigt in stark vereinfachter schematischer Darstellung die prinzipielle Wirkungsweise einer Vorrichtung für die elektrische Funktionsprüfung von Leiterplatten auf der Basis einer berührungslosen ionischen Kontaktierung der Meßstellen über Gasentladungsstrecken. Es ist ein Teil einer mit Lp bezeichneten Leiterplatte zu erkennen, auf deren Oberseite die Enden einer Leiterbahn Lb Meßstellen M10 und M11 bilden. Auf die Oberseite der Leiterplatte Lp ist eine Trägerplatte T10 aus einem isolierenden Material wie z.B. Glas aufgesetzt, in welche in Form von Sacklöchern eine Vielzahl von Gasentladungskanälen eingebracht ist. In der Zeichnung sind dabei nur der der Meßstelle M10 zugeordnete Gasentladungskanal G10 und der der Meßstelle M11 zugeordnete Gasentladungskanal G11 dargestellt. Auf der der Meßstelle M10 gegenüberliegenden Seite des Gasentladungskanals G10 ist eine Elektrode E10 angeordnet, welche über einen als Widerstand wirkenden Photoleiter P10 an eine Sammelleitung S10 angeschlossen ist. In entsprechender Weise ist eine Elektrode E11 des Gasentladungskanals G11 über einen als Widerstand wirkenden Photoleiter P11 an eine Sammelleitung S11 angeschlossen. Über die senkrecht zur Zeichnungsebene verlaufenden Sammelleitungen S10 und S11 sind dabei jeweils die einer Vielzahl von in Fig. 1 nicht dargestellten Gasentladungskanälen zugeordneten Photoleiter reihenweise miteinander verbunden.

Werden nun bei der elektrischen Funktionsprüfung der Leiterplatte Lp die beiden Meßstellen M10 und M11 ausgewählt, so werden die Elektroden E10 und E11 der zugeordneten Gasentladungskanäle G10 und G11 über die Sammelleitungen S10 und S11 und die zugeordneten Photoleiter P10 und P11 angesteuert. Zwischen den Photoleitern P10 und P11 sind dann im Falle einer derartigen Ansteuerung nacheinander in Reihe eine Spannungsquelle Sq, ein Strommeßgerät Sm und ein Wechselspannungserzeuger We angeordnet.

Die gesamte in Fig. 1 dargestellte Anordnung befindet sich in einem evakuierbaren Raum unter einem verminderten Druck von beispielsweise 10 Tor, wobei der evakuierbare Raum mit einem Gas wie z.B. Stickstoff gefüllt ist. Somit sind zwischen der Elektrode E10 und der Meßstelle M10 sowie zwischen der Elektrode E11 und der Meßstelle M11 Gasentladungsstrecken gebildet, die über die Leiterbahn Lb in Reihe geschaltet sind. Die Spannung der Spannungsquelle Sq ist nun derart bemessen, daß an diese beiden in Reihe geschalteten Gasentladungsstrecken die doppelte Zündspannung angelegt ist, sofern die Photoleiter P10 und P11 durch die Einwirkung von Licht L niederohmig geworden sind. Bei dem Licht L handelt es sich beispielsweise um den fokussierten Strahl eines He-Lasers oder eines Ne-Lasers. Bei Verwendung eines akusto-optischen Ablenkers für den Laserstrahl kann die Beaufschlagung der Photoleiter P10 und P11 auch seriell vorgenommen werden, da die Positionierzeit des akusto-optischen Ablenkers klein gegenüber der Rekombinationszeit bzw. Abklingzeit der Photoleiter P10 und P11 ist. Prinzipiell ist eine Zündung von Gasentladungen also nur möglich, wenn die ausgewählten Gasentladungskanäle über ihre zugeordneten Sammelleitungen angesteuert und gleichzeitig oder kurz nacheinander die zugeordneten Photoleiter mit Licht beaufschlagt werden. Auf diese Weise ist dann eine sichere Adressierung der ausgewählten Gasentladungskanäle bzw. Meßstellen gewährleistet.

Zünden nun in den Gasentladungskanälen G10 und G11 Gasentladungen, so kann spätestens zu diesem Zeitpunkt die Beaufschlagung der Photoleiter P10 und P11 mit Licht L beendet werden. Aus dem Brennen der beiden Gasentladungen, das über das in den Stromkreis eingeschaltete Strommeßgerät Sm registriert wird, kann geschlossen werden, das die beiden Meßstellen M10 und M11 elektrisch hinreichend miteinander verbunden sind, bzw. daß die Leiterbahn Lb nicht unterbrochen ist. Für Messungen des Widerstandes zwischen den Meßstellen M10 und M11 wird über den Wechselspannungserzeuger We zusätzlich eine Wechselspannung überlagert, wobei diese Überlagerung wie im dargestellten Ausführungsbeispiel durch induktive Ankoppelung vorgenommen werden kann. Die Widerstandsmessungen werden am differentiellen Umkehrpunkt der Gasentladungscharakteristik vorgenommen, wobei die Innen-Widerstände der Gasentladungsstrecken praktisch wechselstrommäßig überbrückt werden. Dabei führen kleine Schwankungen U der überlagerten Wechselspannung zu relativ großen Schwankungen I des Stromes. Daß im Stromkreis angeordnete phasenempfindliche Strommeßgerät Sm, bei welchem es sich beispielsweise um einen handelsüblichen lock-in-amplifier handeln kann, registriert die Stromschwankungen und der Widerstand R kann aus der Beziehung $R = U/I$ ermittelt werden. Aus der Höhe des ermittelten Widerstandes kann dann gegebenenfalls auf Fehler geschlossen werden, bei welchen die Leiterbahn Lb nur teilweise unterbrochen ist. Außerdem kann die Ermittlung des Widerstandes R auch für Isolationsmessung herangezogen werden.

Fig. 2 zeigt in stark vereinfachter schematischer Darstellung eine Schar von parallelen, teiltransparenten Sammelleitungen, die mit den zugeordneten Gasentladungskanälen jeweils über einen dazwischen in Dünnfilmtechnik angebrachten Photoleiter in Verbindung stehen. Im dargestellten Ausführungsbeispiel sollen die durch eine Leiterbahn Lb miteinander verbundenen Meßstellen M20 und M21 angesteuert werden. Hierzu wird zunächst an die zugeordneten Sammelleitungen S20 und S21 die doppelte Zündspannung 2Uz angelegt. Die Selektion entlang dieser Sammelleitung S20 und S21 erfolgt dann durch die Beaufschlagung der den Meßstellen M20 und M21 zugeordneten Photoleiter P20 bzw. P21 mit Licht L, wobei diese Lichtbeaufschlagung beispielsweise wieder seriell mit einem einzigen ablenkbaren Laserstrahl vorgenommen werden kann. Damit werden dann die Photoleiter P20 und P21 niederohmig und es kann ein hinreichender Strom I zur Zündung und Aufrechterhaltung von Gasentladungen in den entsprechenden Gasentladungskanälen G20 und G21 fließen.

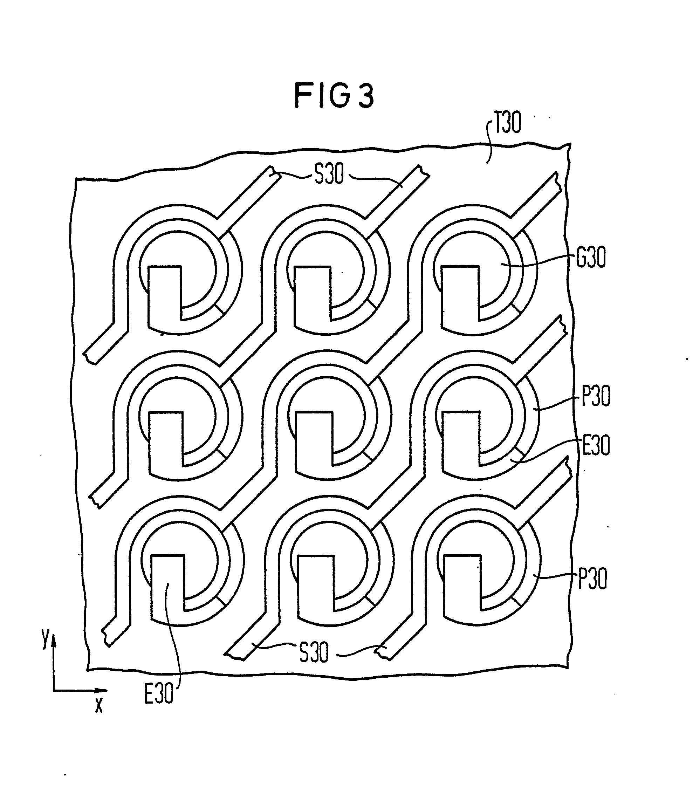

Fig. 3 zeigt eine Draufsicht auf eine Trägerplatte T30 in welche Gasentladungskanäle G30 im Rastermaß der zu prüfenden Verdrähtung eingebracht sind. Auf die Oberfläche der Trägerplatte T30 sind in Dünnfilmtechnik eine Schar paralleler Sammelleitung S30, Photoleiter P30 und Elektroden E30 aufgebracht. Die Sammelleitungen S30 sind dabei in der einen Richtung bogenförmig um die Gasentladungskanäle G30 geführt, während die Photoleiter P30 in der anderen Richtung bogenförmig um die Gasentladungskanäle G30 geführt sind. Die an die Photoleiter P30 sich anschließenden Elektroden E30 nehmen zunächst einen kurzen bogenförmigen Verlauf um dann mit ihren Enden in die entsprechenden Gasentladungskanäle G30 hineinzuragen.

Die Sammelleitungen S30 verlaufen unter einem Winkel von 45° quer zu den Hauptrichtungen x und y der zu prüfenden Verdrah tung. Dies hat den Vorteil, daß auch diejenigen Meßstellen angesteuert werden können, die zunächst der gleichen Sammelleitung zugeordnet sind. In diesem Fall wird dann die gesamte Trägerplatte T30 um einen Winkel von 90° oder 270° relativ zu der zu prüfenden Verdrahtung verdreht. Nach einer derartigen Verdrehung sind dann den beiden Meßstellen zwei verschiedene Sammelleitungen zugeordnet.

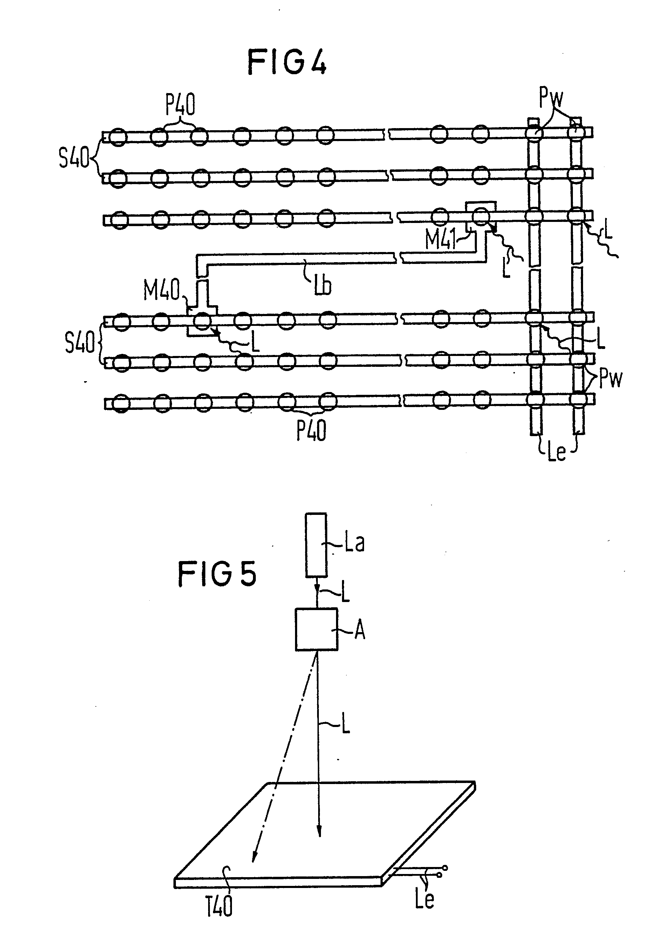

Fig. 4 zeigt eine der Fig. 2 weitgehend entsprechende Anordnung bei welcher jedoch die Ansteuerung der einzelnen Meßstellen durch einen zusätzlichen optischen Multiplexer noch weiter vereinfacht wird. Auf die hier nicht näher dargestellte Trägerplatte sind in Dünnfilmtechnik Photoleiter P40, eine Schar teiltransparenter Sammelleitungen S40, Photowiderstände Pw und zwei sämtliche Sammelleitungen S40 kreuzende teiltransparente Leitungen Le aufgebracht. Die Photoleiter P40 sind als dünne kreisrunde Scheiben ausgebildet, die sich unterhalb der Sammelleitungen S40 befinden und jeweils mit der Elektrode eines in Fig. 4 nicht erkennbaren Gasentladungskanals verbunden sind. Die Photowiderstände Pw, die den Photoleitern P40 entsprechen, sind ebenfalls als dünne kreisrunde Scheiben ausgebildet und jeweils an den Kreuzungsstellen der Sammelleitungen S40 und der Leitungen Le zwischen einer Sammelleitung S40 und einer Leitung Le angeordnet.

In Fig. 4 ist weiterhin eine Leiterbahn Lb zu erkennen, die Meßstellen M40 und M41 miteinander verbindet. Zur Ansteuerung dieser beiden Meßstellen M40 und M41 werden die beiden zugeordneten Photoleiter P40 und die beiden zugeordneten Photowiderstände Pw des optischen Multiplexers mit Licht L beaufschlagt, was im Hinblick auf die Rekombinationszeit bzw. Abklingzeit auch hier wieder mit Hilfe eines akusto-optisch ablenkbaren Laserstrahls vorgenommen wird. Die beiden mit Licht L beaufschlagten Fotoleiter P40 und die beiden mit Licht L beaufschlagten Fotowiderstände Pw werden dann niederohmig, so daß über die beiden Leitungen Le die doppelte Zündspannung an den Gasentladungsstrecken anliegt. Ein Zünden der Gasentladungs strecken bietet dann die Gewähr, daß die Leiterbahn Lb nicht unterbrochen ist.

Fig. 5 zeigt eine perspektivische Gesamtdarstellung der in Fig. 4 schematisch aufgezeigten Vorrichtung. Es ist eine Trägerplatte T40 für beispielsweise 1000 $\times$ 1000 Rasterpunkte dargestellt, wobei jedem Rasterpunkt ein Photoleiter P40 gemäß Fig. 4 zugeordnet ist. Den beiden Leitungen Le sind dann 2000 Photowiderstände Pw gemäß Fig. 4 zugeordnet. Oberhalb der Trägerplatte T40 befindet sich ein Laser La, wie z.B. ein He-Laser oder Ne-Laser, dessen Strahl als Licht L auf jeden der $10^6$ Photoleiter und der 2000 Photowiderstände gerichtet werden kann. Die Ablenkung erfolgt dabei über einen akusto-optischen Ablenker A. Für die Ansteuerung der einzelnen Meßstellen mit $10^{12}$ Verbindungsmöglichkeiten benötigt man also nur einen ablenkbaren Strahl und die beiden Leitungen Le.

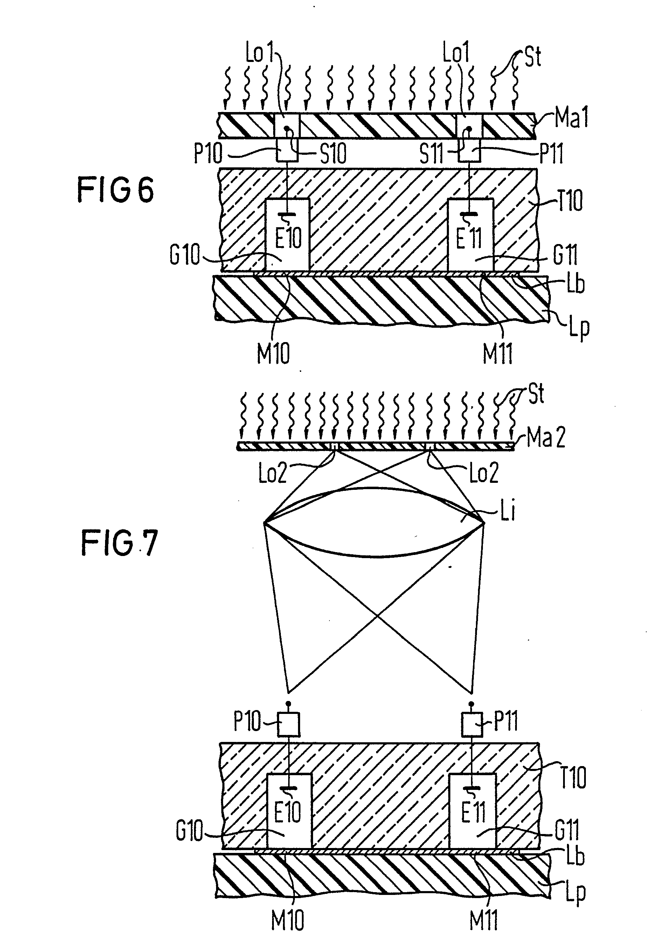

Fig. 6 zeigt eine erste Variante des in Fig. 1 aufgezeigten Grundprinzips. Die Lichtbeaufschlagung der ausgewählten Photoleiter erfolgt hier über eine flächenförmig verteilte Strahlung St und eine auf die Trägerplatte T10 aufgesetzte Maske Ma1. Die Maske Ma1 läßt die Strahlung nur im Bereich von Löchern Lo1 durch, die den ausgewählten Gasentladungskanälen G10 und G11 bzw. den Meßstellen M10 und M11 zugeordnet sind. Es ist ersichtlich, daß die gezielte Beaufschlagung ausgewählter Photoleiter und gegebenenfalls auch ausgewählter Photowiderstände Pw gemäß Fig. 4 über die jeweilige Lage von Löchern Lo1 einer Maske Ma1 oder mehrerer Masken gesteuert werden kann.

Fig. 7 zeigt eine zweite Variante des in Fig. 1 aufgezeigten Grundprinzips. Hier beleuchtet die Strahlung St eine Maske Ma2 deren Löcher Lo2 über ein Linsensystem Li auf die Photoleiter P10 und P11 abgebildet werden und damit deren Beaufschlagung mit Licht bewirken.

**Ansprüche**

1. Vorrichtung für die elektrische Funktionsprüfung von Verdrahtungsfeldern, insbesondere von Leiterplatten, mit einer auf die Verdrahtungsfelder aufsetzbaren und mit einer Vielzahl von Gasentladungskanälen versehenen Trägerplatte, wobei jeweils mindestens zwei ausgewählte Meßstellen eines Verdrahtungsfeldes über die zugeordneten Gasentladungskanäle vorzugsweise ionisch kontaktierbar sind,
**dadurch gekennzeichnet,**
daß jeder Gasentladungskanal (G10, G11; G20, G21; G30) durch eine zugeordnete Sammelleitung (S10, S11; S20, S21; S30; S40) und durch die steuerbare Beaufschlagung eines zwischen dem Gasentladungskanal (G10, G11; G20, G21; G30) und der zugeordneten Sammelleitung (S10, S11; S20, S21; S30; S40) angeordneten Photoleiters (P10, P11; P20, P21; P30; P40) mit Licht (L) auswählbar ist.

2. Vorrichtung nach Anspruch 1,
**dadurch gekennzeichnet,**
daß die den Gasentladungskanälen (G10, G11; G20, G21; G30) zugeordneten Photoleiter (P10, P11; P20, P21; P30; P40) reihenweise über die Sammelleitungen (S10, S11; S20, S21; S30; S40) miteinander verbunden sind.

3. Vorrichtung nach einem der vorhergehenden Ansprüche,
**dadurch gekennzeichnet,**
daß die Sammelleitungen (S30) quer zu den Hauptrichtungen (x,y) der Verdrahtung der zu prüfenden Verdrahtungsfelder verlaufen.

4. Vorrichtung nach einem der vorhergehenden Ansprüche,
**dadurch gekennzeichnet,**
daß jede Sammelleitung (S40) über jeweils einen Photowiderstand (Pw) mit zwei Leitungen (Le) verbunden ist und daß jeder Photowiderstand (Pw) steuerbar mit Licht (L) beaufschlagbar ist.

5. Vorrichtung nach einem der vorhergehenden Ansprüche,

**dadurch gekennzeichnet,**

daß die Sammelleitungen (S30) bogenförmig um die Gasentladungskanäle (G30) geführt sind.

6. Vorrichtung nach einem der vorhergehenden Ansprüche,

**dadurch gekennzeichnet,**

daß die Photoleiter (P30) bogenförmig um die Gasentladungskanäle (G30) geführt sind.

7. Vorrichtung nach einem der vorhergehenden Ansprüche,

**dadurch gekennzeichnet,**

daß die Photoleiter (P10, P11; P20, P21; P30; P40) aus Cadmiumselenid oder Cadmiumsulfid bestehen.

8. Vorrichtung nach einem der vorhergehenden Ansprüche,

**dadurch gekennzeichnet,**

daß die Photoleiter (P30) an zugeordnete Elektroden (E30) der Gasentladungskanäle (G30) angeschlossen sind.

9. Vorrichtung nach einem der vorhergehenden Ansprüche,

**dadurch gekennzeichnet,**

daß die Sammelleitungen (S30; S40) in Dünnfilmtechnik hergestellt sind.

10. Vorrichtung nach einem der vorhergehenden Ansprüche,

**dadurch gekennzeichnet,**

daß die Photoleiter (P30; P40) in Dünnfilmtechnik hergestellt sind.

11. Vorrichtung nach einem der Ansprüche 4 bis 10,

**dadurch gekennzeichnet,**

daß die Photowiderstände (Pw), in Dünnfilmtechnik hergestellt sind.

12. Vorrichtung nach einem der Ansprüche 4 bis 11,

**dadurch gekennzeichnet,**

daß die beiden Leitungen (Le) in Dünnfilmtechnik hergestellt sind.

13. Vorrichtung nach den Ansprüchen 9 bis 12,

**dadurch gekennzeichnet,**

daß die Sammelleitungen (S40) die Photoleiter (P40), die Photowiderstände (Pw) und die beiden Leitungen (Le) in Dünnfilmtechnik auf die Trägerplatte (T40) aufgebracht sind.

14. Vorrichtung nach einem der vorhergehenden Ansprüche,

**dadurch gekennzeichnet,**

daß die Photoleiter (P10, P11) über eine Maske (Ma1;Ma2) mit Licht beaufschlagbar sind.

15. Vorrichtung nach einem der Ansprüche 4 bis 14,

**dadurch gekennzeichnet,**

daß die Photowiderstände über eine Maske (Ma1;Ma2) mit Licht beaufschlagbar sind.

16. Vorrichtung nach einem der Ansprüche 1 bis 13,

**dadurch gekennzeichnet,**

daß die Photoleiter (P10, P11; P20; P21; P30; P40) über einen ablenkbaren Strahl mit Licht (L) beaufschlagbar sind.

17. Vorrichtung nach einem der Ansprüche 4 bis 13 oder 16,

**dadurch gekennzeichnet,**

daß die Photowiderstände (Pw) über einen ablenkbaren Strahl mit Licht (L) beaufschlagbar sind.

18. Vorrichtung nach Anspruch 16 oder 17,

**dadurch gekennzeichnet,**

daß der Strahl durch einen fokussierbaren Laserstrahl gebildet ist.

19. Vorrichtung nach einem der Ansprüche 16 bis 18,

**dadurch gekennzeichnet,**

daß zur Ablenkung des Strahls ein akusto-optischer Ablenker (A) vorgesehen ist.

20. Vorrichtung nach einem der Ansprüche 16 bis 19,

**dadurch gekennzeichnet,**

daß die Photoleiter (P10, P11; P20, P21; P30; P40) seriell mit Licht (L) beaufschlagbar sind.

21. Vorrichtung nach einem der Ansprüche 17 bis 20,

**dadurch gekennzeichnet,**

daß die Photowiderstände (Pw) seriell mit Licht (L) beaufschlagbar sind.

22. Vorrichtung nach den Ansprüchen 20 und 21,

**dadurch gekennzeichnet,**

daß die Photoleiter (P40) und die Photowiderstände (Pw) seriell mit Licht (L) beaufschlagbar sind.

# FIG 1

# FIG 2

# FIG 3

## FIG 4

P40

S40

Pw

M41

L

L

M40

Lb

S40

L

L

Pw

P40

Le

## FIG 5

La

L

A

L

L

T40

Le

FIG 6

FIG 7